## Europäisches Patentamt

## European Patent Office

## Office européen des brevets

(19)

(11) Veröffentlichungsnummer: **0 359 866**
**A1**

## EUROPÄISCHE PATENTANMELDUNG

(12)

(21) Anmeldenummer: 88115723.4

(51) Int. Cl.⁵: **G01R 31/26**

(22) Anmeldetag: 23.09.88

(43) Veröffentlichungstag der Anmeldung:
28.03.90 Patentblatt 90/13

(84) Benannte Vertragsstaaten:
AT BE CH DE ES FR GB GR IT LI LU NL SE

(71) Anmelder: **Siemens Aktiengesellschaft**
**Wittelsbacherplatz 2**
**D-8000 München 2(DE)**

(72) Erfinder: **Feldtkeller, Martin, Dipl.-Ing.**
**Josephsburgstrasse 59**
**D-8000 München 80(DE)**
Erfinder: **Horchler, Wolfgang, Dipl.-Ing.**
**Bahnhofplatz 12**
**D-8013 Haar(DE)**

(54) **Verfahren und Halbleiteranordnung zum Messen der Stromaufnahme einer monolithisch integrierten Leistungsstruktur.**

(57) Verfahren und Halbleiteranordnung zum Messen der Stromaufnahme einer monolithisch integrierten Leistungsstruktur, wobei eine erste, eine Leiterbahn bildende mit elektrischem Widerstand behaftete leitende Schicht (L1) zum Zuführen eines Versorgungspotentials von einer leitenden Kontaktfläche (K) zur monolithisch integrierten Leistungsstruktur vorgesehen ist, wobei zum Ermitteln der Stromaufnahme dieser Leistungsstruktur die Spannung zwischen einem ersten und einem zweiten an der ersten leitende Schicht (L1) angeordneten Meßpunkt (M1, M2) gemessen wird, wobei der erste und der zweite Meßpunkt (M1, M2) im Normalbetrieb der monolithisch integrierten Leistungsstruktur unterschiedliches Potential aufweisen, wobei erfindungsgemäß entlang einer sich über den Querschnitt der ersten leitenden Schicht erstreckenden ersten Linie (EL1) Widerstände (W1) jeweils mit ihrem ersten Anschluß an diese erste leitende Schicht (L1) angeschlossen sind und der zweite Anschluß eines jeden dieser Widerstände (W1) an eine zweite leitende Schicht (BL1) angeschlossen ist, wobei das an dieser zweiten leitenden Schicht (BL1) anliegende Potential einer Mittelung der an der entlang der sich über den Querschnitt der ersten leitenden Schicht erstreckenden ersten Linie (EL1) anliegenden Potentiale entspricht und wobei der besagte erste Meßpunkt (M1) an dieser zweiten leitenden Schicht (BL1) liegt. Eine günstige Ausführungsform sieht auch für den zweiten Meßpunkt (M2) eine entsprechende Anordnung vor.

EP 0 359 866 A1

## FIG 1

## Verfahren und Halbleiteranordnung zum Messen der Stromaufnahme einer monolithisch integrierten Leistungsstruktur

Die Erfindung betrifft ein Verfahren zum Messen der Stromaufnahme einer monolithisch integrierten Leistungsstruktur nach dem Oberbegriff des Patentanspruches 1 sowie eine Halbleiteranordnung zur Durchführung des Verfahrens.

Um monolithisch integrierte Leistungsstrukturen wie z. B. Leistungstransistoren oder die Zusammenschaltung mehrerer Leistungstransistoren, Leistungsoperationsverstärker etc. vor Überlastung zu schützen, muß der über sie fließende Strom gemessen werden. Üblicherweise dient die Spannung, die über einem Teilstück der Leiterbahn abfällt, die die Leistungsstruktur mit der Kontaktierfläche verbindet, als Maß für den Strom, der von der entsprechenden Leistungsstruktur aufgenommen wird. Bei einem bekannten Verfahren zum Messen der Stromaufnahme einer monolithisch integrierten Leistungsstruktur wird in die Verbindung, die zwischen einer Kontaktierfläche und der Leistungsstruktur vorgesehen ist, ein mit einem Widerstand behafteter Leiter mit definierten Abmessungen zwischen zwei Meßpunkten so eingebaut, daß sich zwischen diesen beiden Meßpunkten innerhalb dieses Leiters eine homogene Stromverteilung einstellt. Ein Vorteil eines solchen Verfahrens ist darin zu sehen, daß auch bei partieller Zunahme des aufgenommenen Stromes mit Sicherheit eine Zunahme des Gesamtstroms festgestellt werden kann. Allerdings ist zur Durchführung eines solchen Meßverfahrens eine relativ große Chipfläche erforderlich, was mit Kosten verbunden ist.

Ein anderes bekanntes Verfahren zur Messung der Stromaufnahme monolithisch integrierter Leistungsstrukturen kommt mit geringerem Chipflächenaufwand aus. Hierzu wird die Leistungsstruktur über eine Leiterbahn mit geringem Chipflächenbedarf mit der Kontaktierfläche verbunden. An zwei von der Kontaktierfläche unterschiedlich weit entfernten Punkten dieser Leiterbahn ist jeweils ein Potentialmeßpunkt in Form eines Abgriffes vorgesehen. Der von der Leistungsstruktur über die Kontaktierfläche aufgenommene oder an sie abgegebene Strom wird durch Messen der Spannung zwischen diesen beiden Potentialmeßpunkten ermittelt. Weist die betreffende Leistungsstruktur nicht nur eine, sondern mehrere Versorgungsspannungseingänge auf, die über die gleiche Kontaktierfläche mit Energie versorgt werden, so muß bei einem solchen Verfahren davon ausgegangen werden, daß sich der Gesamtstrom gleichmäßig auf die Leistungsstruktur und somit auf die einzelnen Äste eines erforderlichen Leiterbahnenbaumes verteilt. Unterliegt die Stromverteilung beispielsweise einer Exemplarstreuung, so unterliegt auch eine von einer nach diesem Verfahren durchgeführten Messung abhängige Strombegrenzung einer Streuung.

Aufgabe der Erfindung ist das Bereitsstellen eines Verfahrens zum Messen der Stromaufnahme monolithisch integrierter Leistungsstrukturen, das unter Umgehung der jeweiligen Nachteile die Vorteile der obengenannten Verfahren in sich vereint sowie einer Halbleiteranordnung zur Durchführung des Verfahrens.

Diese Aufgabe wird durch ein Verfahren nach dem Patentanspruch 1 bzw. eine Halbleiteranordnung nach dem Patentanspruch 12 gelöst. Günstige Ausgestaltungsformen erfindungsgemäßer Verfahren sind Gegenstand von Unteransprüchen.

Damit die Stromverteilung in einer mit Widerstand behafteten stromdurchflossenen ersten leitenden Schicht L1, die insbesondere als baumförmige Leiterbahnstruktur ausgebildet ist, keinen oder nur einen geringen Einfluß auf die zwischen zwei Meßpunkten an dieser Leiterbahnstruktur ermittelten Spannung haben kann, muß die Messung das Potentialgefälle über den gesamten Leiterquerschnitt berücksichtigen. Falls der zweite Meßpunkt M2 beispielsweise im Bereich der leitenden Kontaktfläche K so gewählt werden kann, daß die Stromverteilung keinen Einfluß auf das in diesem Fall als konstant anzunehmende Potential hat, so muß die Stromverteilung über den Leiterquerschnitt nur für den ersten Meßpunkt M1 berücksichtigt werden. Sonst muß das Potentialgefälle für beide Meßpunkte jeweils über den Leiterquerschnitt gemittelt werden. Hierzu werden erfindungsgemäß entweder eine erste Linie EL1 oder eine erste und eine zweite Linie EL1 bzw. EL2 gewählt, die sich jeweils über den Querschnitt der als Leiterbahn ausgebildeten ersten leitenden Schicht L1 erstrecken. Entlang dieser Linie werden Widerstände W1 bzw. W2 mit der ersten leitenden Schicht L1 kontaktiert. Die entlang einer Linie kontaktierten Widerstände können hierbei insbesondere den gleichen Widerstandswert aufweisen. Die entlang unterschiedlicher Linien an die erste leitende Schicht L1 angeschlossenen Widerstände können hierbei unterschiedlich groß sein.

Die entlang der ersten Linie EL1 mit der ersten leitenden Schicht L1 kontaktierten Widerstände W1 sind mit ihrem jeweiligen anderen Anschluß an eine zweite leitende Schicht BL1 angeschlossen. Fließt innerhalb dieser zweiten leitenden Schicht maximal ein Strom, insbesondere ein Meßstrom, der so klein ist, daß diese zweite leitende Schicht aufgrund ihrer Leitfähigkeit als nahezu Äquipotential angenommen werden kann, so liegt sie auf einem Potential, das den über die Widerstände W1 gemittelten Potentialen an den einzelnen Kontaktstellen zwischen den Widerständen W1 und der ersten leitenden Schicht L1 entspricht. Ist die erste leitende Schicht L1 beispielsweise als Leiterbahnenbaum-Struktur ausgebildet und ist der Strom in einem Ast dieses Baumes gegenüber dem Strom im übrigen Bereich der Leiterbahn erhöht, so bewirkt die dadurch bedingte Potentialänderung innerhalb dieses Astes, falls die erste Linie EL1 über diesem Ast verläuft, am an der zweiten leitenden Schicht BL1 angeordneten ersten Meßpunkt M1 trotzdem nur eine Potentialänderung, die der Änderung des Gesamtstromes entspricht. Ob das Potential bei einer Stromänderung größer oder kleiner wird, hängt in diesem Fall von der Stromflußrichtung bzw. der Polarität der an der leitenden Kontaktfläche K anliegenden Spannung ab.

Nachstehend wird das erfindungsgemäße Verfahren anhand der Figuren näher erläutert.

Figur 1 zeigt in der Draufsicht eine mögliche, besonders günstige Ausführungsform einer Halbleiteranordnung zur Durchführung eines erfindungsgemäßen Verfahrens.

Figur 2 zeigt nicht maßstäblich einen Schnitt durch einen Teil der in Figur 1 dargestellten Halbleiteranordnung und zwar entlang der Schnittlinie II, die in Figur 1 eingezeichnet ist.

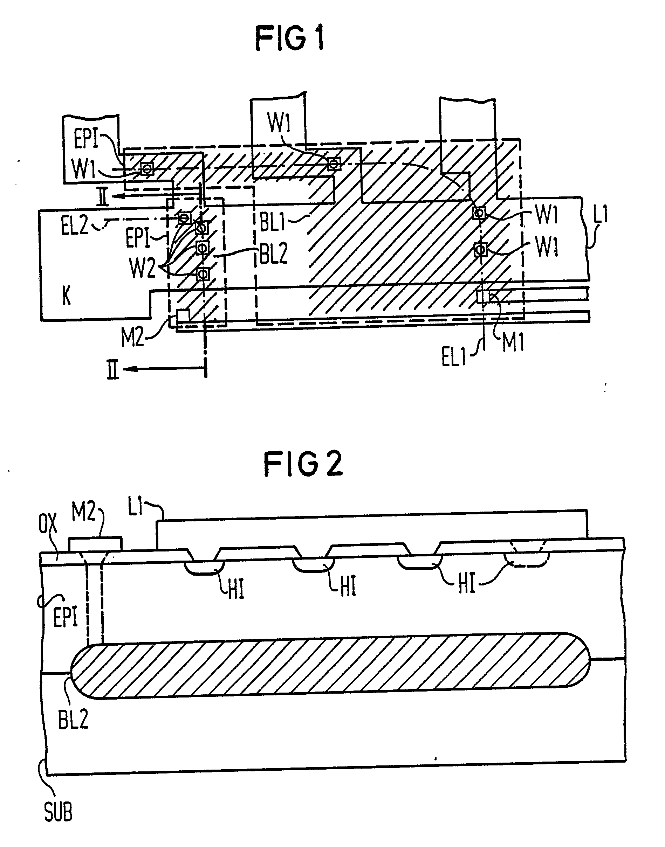

Die in den Figuren dargestellte Halbleiteranordnung besteht aus einem Halbleitersubstrat SUB vom einen Leitungstyp, das beispielsweise p-leitendes Silizium sein kann. Auf dieser Halbleitersubstratschicht SUB, die in Figur 1 nicht durch Linien begrenzt ist, sind zwei jeweils in ihrer Ausdehnung begrenzte, nicht zusammenhängende Epitaxieschichten EPI, beispielsweise in Form von sogenannten Epitaxiewannen vom zum Leistungstyp des Halbleitersubstrates SUB komplementären Leitungstyp angeordnet, die in Figur 1 jeweils durch eine unterbrochene Linie dargestellt sind. Die Epitaxieschichten EPI sind mit einer isolierenden Schicht OX bedeckt, die beispielsweise eine Oxidschicht sein kann und auf dieser Oxidschicht ist die erste leitende Schicht L1 angeordnet, die mit einer leitenden Kontaktfläche K verbunden ist und eine baumförmige Leiterbahnstruktur aufweist.

Im Berührungsbereich zwischen den Epitaxieschichten EPI und dem Halbleitersubstrat SUB sind jeweils eine erste und eine zweite vergrabene Schicht BL1 bzw. BL2, sogenannte Buried Layer, eingebracht, die in den Figuren als schraffierte Felder dargestellt sind, wobei in Figur 1 aus Gründen der Übersichtlichkeit keine gesonderte Einrahmung dieser schraffiert dargestellten Felder vorgenommen ist. Die erste vergrabene Schicht BL1 unterlegt die erste leitende Schicht L1 im Bereich einer sich über deren Querschnitt erstreckenden ersten Linie EL1 und kann auch noch über die von der ersten leitenden Schicht L1 abgedeckte Fläche hinausragen. Die zweite vergrabene Schicht BL2 unterlegt die erste leitende Schicht L1 im Bereich einer sich über deren Querschnitt erstreckenden zweiten Linie EL2 und kann auch noch über die von der ersten leitenden Schicht L1 abgedeckte Fläche hinausragen. Beide vergrabenen Schichten BL1 und BL2 erstrecken sich in der in der ersten leitenden Schicht L1 üblichen Stromflußrichtung jeweils nur über einen jeweils anderen Teil der Länge dieser ersten leitenden Schicht L1. Entlang der ersten Linie EL1 ist die isolierende Schicht OX in Form kleiner Fenster unterbrochen und im Bereich dieser Unterbrechungen sind jeweils hochdotierte inselförmige in die Epitaxieschicht EPI hineinreichende Halbleiterbereiche HI vom gleichen Leitungstyp wie die Epitaxieschicht EPI angebracht, die insbesondere gleichgroß sein können, die mit der ersten leitenden Schicht L1 kontaktiert sind und somit über die hochohmige Epitaxieschicht EPI jeweils zwischen der Kontaktstelle mit der ersten leitenden Schicht und der ersten vergrabenen Schicht BL1 Widerstände W1 bilden. Der erste Meßpunkt M1 ist an die erste vergrabene Schicht BL1 angeschlossen. Entlang der zweiten Linie EL2 ist die isolierende Schicht OX in Form kleiner Fenster unterbrochen und im Bereich dieser Unterbrechungen sind jeweils gleichgroße hochdotierte inselförmige in die Epitaxieschicht EPI hineinreichende Halbleiterbereiche HI vom gleichen Leitungstyp wie die Epitaxieschicht EPI angebracht, die mit der ersten leitenden Schicht L1 kontaktiert sind und somit über die hochohmige Epitaxieschicht EPI jeweils zwischen der Kontaktstelle mit der ersten leitenden Schicht und der zweiten vergrabenen Schicht BL2 Widerstände W2 bilden. Der zweite Meßpunkt M2 ist an die zweite vergrabene Schicht BL2 angeschlossen. Die vergrabenen Schichten BL1 bzw. BL2 können hierbei jeweils über eine durch die isolierende Schicht OX und die Epitaxieschicht EPI geführte Leiterstruktur an die zu den Meßpunkten M1 und M2 geführten Meßleitungen angeschlossen sein oder durch identische Widerstandsstrukturen, wie sie entlang der ersten bzw. zweiten Linie EL1, EL2 zwischen der ersten leitenden Schicht L1 und der jeweiligen vergrabenen Schicht BL1 bzw. BL2 vorgesehen sind.

An den vergrabenen Schichten liegt bei solchen Anordnungen jeweils das über die entsprechende Linie EL1 und EL2 gemittelte mit der Anordnungsdichte der gleichgroßen Widerstände W1 bzw. W2 gewichtete Potential der ersten leitenden Schicht L1.

Zu einem erfindungsgemäßen Verfahren genügt es auch, die erste leitende Schicht L1 ohne Zwischenschaltung einer Epitaxieschicht EPI und ohne hochdotierte Halbleiterbereiche HI durch eine isolierende Schicht OX von einer zweiten bzw. dritten leitenden Schicht BL1 bzw. BL2 zu trennen und entlang der ersten Linie EL1 bzw. entlang der zweiten Linie EL2 fensterförmige Unterbrechungen in der isolierenden Schicht vorzusehen und im Bereich dieser Unterbrechungen die erste leitende Schicht L1 unmittelbar mit der zweiten leitenden Schicht BL1 bzw. der dritten leitenden Schicht BL2 zu kontaktieren, wenn die Leitfähigkeit der zweiten bzw. dritten leitenden Schicht kleiner ist als die Leitfähigkeit der ersten leitenden Schicht L1. In diesem Fall kann der Widerstandswert des sich im Kontaktbereich einstellenden Widerstandes W1 bzw. W2 jeweils durch die Größe der einzelnen Kontaktflächen variiert werden.

In Abwandlung einer solchen Ausführungsform eines erfindungsgemäßen Verfahrens sind im Bereich der fensterförmigen Unterbrechungen der isolierenden Schicht jeweils Widerstände derart eingebracht, daß Material von geringerer Leitfähigkeit als die der ersten leitenden Schicht L1 und von geringerer Leitfähigkeit als die der zweiten leitenden Schicht bzw. dritten leitenden Schicht BL1, BL2 mit der ersten leitenden Schicht L1 und mit der zweiten leitenden Schicht bzw. dritten leitenden Schicht BL1, BL2 kontaktiert ist.

Der Einfluß der Stromverteilung auf das gemessene Potential ist besonders gering, wenn als erste und zweite Linie EL1 bzw. EL2 sich bei einer durchschnittlich zu erwartenden Stromverteilung ergebende Äquipotentiallinien gewählt werden und mit der sich dabei ergebenden Stromdichte gewichtet werden. Diese Äquipotentiallinien können experimentell ermittelt werden oder bei geeigneter Symmetrie der Anordnung errechnet werden. Die Stromdichte in der ersten leitenden Schicht L1 und die erforderliche Anordnungsdichte der in diesem Falle gleichgroßen Widerstände W1 bzw. W2 steht in proportionalem Zusammenhang zum Potentialgefälle, d.h. zur Dichte der Äquipotentiallinien innerhalb der ersten leitenden Schicht.

Wenn als erste Linie EL1 bzw. als zweite Linie EL2 Äquipotentiallinien gewählt sind, sollten die einzelnen entlang dieser Linien angeordneten Widerstände W1 bzw. W2 jeweils gleichgroß sein, wenn ihre Anordnungsdichte homogen ist. Ansonsten kann die Anordnungsdichte der Widerstände auf dieser ersten bzw. zweiten Linie EL1, EL2 sowie der jeweilige Widerstandswert der einzelnen Widerstände W1, W2 in Abhängigkeit von der in der ersten leitenden Schicht im normalen Betriebsfall vorliegenden Stromdichte und in Abhängigkeit von der im normalen Betriebsfall jeweils auf den einzelnen Linien EL1, EL2 vorliegenden Potentialverteilung variiert werden.

Anstelle der Anordnungsdichte der Widerstände W1 bzw. W2 oder zusammen mit der Anordnungsdichte dieser Widerstände ist es auch möglich, die Leitwert der Widerstände bzw. das Produkt aus Leitwert und Anordnungsdichte proportional zur Stromdichte zu wählen, indem die Größe der Fenster in der isolierenden Schicht OX und damit jeweils das Ausmaß der Halbleiterbereiche HI variiert wird.

## Ansprüche

1. Verfahren zum Messen der Stromaufnahme einer monolithisch integrierten Leistungsstruktur, wobei eine erste, eine Leiterbahn bildende mit elektrischem Widerstand behaftete leitende Schicht (L1) zum Zuführen eines Versorgungspotentials von einer leitenden Kontaktfläche (K) zur monolithisch integrierten Leistungsstruktur vorgesehen ist, wobei zum Ermitteln der Stromaufnahme dieser Leistungsstruktur die Spannung zwischen einem ersten und einem zweiten an der ersten leitende Schicht (L1) angeordneten Meßpunkt (M1, M2) gemessen wird, wobei der erste und der zweite Meßpunkt (M1, M2) im Normalbetrieb der monolithisch integrierten Leistungsstruktur unterschiedliches Potential aufweisen,
**dadurch gekennzeichnet,**
daß entlang einer sich über den Querschnitt der ersten leitenden Schicht erstreckenden ersten Linie (EL1) Widerstände (W1) jeweils mit ihrem ersten Anschluß an diese erste leitende Schicht (L1) angeschlossen sind, daß der zweite Anschluß eines jeden dieser Widerstände (W1) an eine zweite leitende Schicht (BL1) angeschlossen ist, wobei das an dieser zweiten leitenden Schicht (BL1) anliegende Potential einer Mittelung der an der entlang der sich über den Querschnitt der ersten leitenden Schicht erstreckenden ersten Linie (EL1) anliegenden Potentiale entspricht und daß der besagte erste Meßpunkt (M1) an dieser zweiten leitenden Schicht (BL1) liegt.

2. Verfahren nach Anspruch 1,
**dadurch gekennzeichnet,**
daß außerdem entlang einer weiteren sich über den Querschnitt der ersten leitenden Schicht (L1) erstreckenden zweiten Linie (EL2) Widerstände (W2) jeweils mit ihrem ersten Anschluß an die erste leitende Schicht (L1) angeschlossen sind, daß der zweite Anschluß eines jeden dieser entlang der zweiten Linie (EL2) angeschlossenen Widerstände (W2) an eine dritte leitende Schicht (BL2) angeschlossen ist und daß der zweite Meßpunkt (M2) an dieser dritten leitenden Schicht (BL2) liegt.

3. Verfahren nach einem der vorhergehenden Ansprüche,
**dadurch gekennzeichnet,**
daß die erste und die zweite sich über den Querschnitt der ersten leitenden Schicht erstreckende Linie (EP1, EP2) bei Normalbetrieb der monolithisch integrierten Leistungsstruktur jeweils einer Äquipotentiallinie mit unterschiedlichem Potential entspricht.

4. Verfahren nach einem der vorhergehenden Ansprüche,

**dadurch gekennzeichnet,**

daß die zweite leitende Schicht (BL1) parallel zur ersten leitenden Schicht (L1) angeordnet ist und von dieser durch eine isolierende Schicht (OX) getrennt ist, daß entlang der sich über den Querschnitt der ersten leitenden Schicht erstreckenden ersten Linie (EP1) mehrere räumlich begrenzte Öffnungen in der isolierenden Schicht vorgesehen sind und diese Öffnungen in der isolierenden Schicht durch mit elektrischem Widerstand behaftetes Material ausgefüllt sind, das sowohl mit der ersten als auch mit der zweiten leitenden Schicht kontaktiert ist und somit die besagten Widerstände (W1) bildet.

5. Verfahren nach einem der Ansprüche 1, 2, oder 3,

**dadurch gekennzeichnet,**

daß die zweite leitende Schicht (BL1) parallel zur ersten leitenden Schicht (L1) angeordnet ist und von dieser durch eine isolierende Schicht (OX) getrennt ist, daß die zweite leitende Schicht (BL1) von geringerer Leitfähigkeit ist als die erste leitende Schicht (L1), daß entlang der sich über den Querschnitt der ersten leitenden Schicht erstreckenden ersten Linie (EL1) mehrere räumlich begrenzte Öffnungen in der isolierenden Schicht (OX) vorgesehen sind und in diesen Öffnungen die erste leitende Schicht (L1) mit der zweiten leitenden Schicht (BL1) kontaktiert ist, daß die Ausdehnung der Öffnungen in der isolierenden Schicht (OX) sehr viel kleiner ist als der Abstand zwischen den Öffnungen und sehr viel kleiner ist als die Ausdehnung der zweiten leitenden Schicht (BL1) in der in der ersten leitenden Schicht (L1) vorherrschenden Stromflußrichtung und daß die Widerstände (W1) durch die sich aufgrund der kleinen Kontaktflächen zwischen der ersten leitenden Schicht (L1) und der zweiten leitenden Schicht (BL1) einstellenden lokalen elektrischen Widerstände realisiert sind.

6. Verfahren nach einem der Ansprüche 1, 2, oder 3,

**dadurch gekennzeichnet,**

daß die dritte leitende Schicht (BL2) parallel zur ersten leitenden Schicht (L1) angeordnet ist und von dieser durch eine isolierende Schicht (OX) getrennt ist, daß die dritte leitende Schicht (BL2) von geringerer Leitfähigkeit ist als die erste leitende Schicht (L1), daß entlang der sich über den Querschnitt der ersten leitenden Schicht erstreckenden zweiten Linie (EL2) mehrere räumlich begrenzte Öffnungen in der isolierenden Schicht (OX) vorgesehen sind und in diesen Öffnungen die erste leitende Schicht (L1) mit der dritten leitenden Schicht (BL2) kontaktiert ist, daß die Ausdehnung der Öffnungen in der isolierenden Schicht (OX) sehr viel kleiner ist als der Abstand zwischen den Öffnungen und sehr viel kleiner ist als die Ausdehnung der dritten leitenden Schicht (BL2) in der in der ersten leitenden Schicht (L1) vorherrschenden Stromflußrichtung und daß die Widerstände (W2) durch die sich aufgrund der kleinen Kontaktflächen zwischen der ersten leitenden Schicht (L1) und der dritten leitenden Schicht (BL2) einstellenden lokalen elektrischen Widerstände realisiert sind.

7. Verfahren nach einem der vorhergehenden Ansprüche,

**dadurch gekennzeichnet,**

daß die Anordnungsdichte der entlang der sich über den Querschnitt der ersten leitenden Schicht (L1) erstreckenden ersten Linie (EL1) angeordneten Widerstände (W1) bzw. die Anordnungsdichte der entlang der sich über den Querschnitt der ersten leitenden Schicht erstreckenden zweiten Linie (EL2) angeordneten Widerstände (W2) proportional zur in der ersten leitenden Schicht vorgegebenen Stromdichte gewählt ist.

8. Verfahren nach einem der vorhergehenden Ansprüche,

**dadurch gekennzeichnet,**

daß die Widerstände (W1 bzw. W2) nicht gleichgroß sind und daß das Produkt aus dem Leitwert der Widerstände (W1 bzw. W2) und der Anordnungsdichte der Widerstände proportional zur Stromdichte innerhalb der ersten leitenden Schicht (L1) ist.

9. Verfahren nach einem der vorhergehenden Ansprüche,

**dadurch gekennzeichnet,**

daß die erste leitende Schicht (L1) aus einem metallischen Leiter besteht.

10. Verfahren nach einem der vorhergehenden Ansprüche,

**dadurch gekennzeichnet,**

daß die erste leitende Schicht (L1) aus Halbleitermaterial besteht.

11. Verfahren nach einem der Ansprüche 2, 3, 4, 5, 6, 7, 8, 9 oder 10,

**dadurch gekennzeichnet,**

daß die dritte leitende Schicht (BL2) parallel zur ersten leitenden Schicht (L1) angeordnet ist und von dieser durch eine isolierende Schicht (OX) getrennt ist, daß entlang der sich über den Querschnitt der ersten leitenden Schicht erstreckenden zweiten Linie (EL2) mehrere räumlich begrenzte Öffnungen in der isolierenden Schicht vorgesehen sind und diese Öffnungen in der isolierenden Schicht durch mit elektrischem Widerstand behaftetes Material ausgefüllt sind, das sowohl mit der ersten als auch mit der dritten leitenden Schicht kontaktiert ist und somit die besagten gleichgroßen Widerstände (W2) bildet.

12. Halbleiteranordnung zur Durchführung eines erfindungsgemäßen Verfahrens, die aus einer Halbleitersubstratschicht (SUB) vom einen Leitungstyp, aus einer auf dieser Halbleitersubstratschicht (SUB) sich befindenden schwachdotierten Epitaxieschicht (EPI) vom zum Leitungstyp der Halbleitersubstratschicht (SUB) komplementären Leitungstyp und aus einer diese Epitaxieschicht (EPI) bedeckenden isolierenden Schicht (OX) besteht und daß eine erste leitende Schicht (L1) auf dieser isolierenden Schicht (OX) angeordnet ist,

**dadurch gekennzeichnet,**

daß als eine zweite leitende Schicht (BL1) eine hochdotierte vergrabene Schicht vom selben Leitungstyp wie die Epitaxieschicht (EPI) im Berührungsbereich zwischen der Epitaxieschicht (EPI) und der Halbleitersubstratschicht (SUB) eingebracht ist, daß sich diese vergrabene Schicht quer zur in der ersten leitenden Schicht (L1) üblichen Stromflußrichtung mindestens über die gesamte Breite unterhalb der ersten leitenden Schicht (L1) erstreckt und in der in der ersten leitenden Schicht (L1) üblichen Stromflußrichtung nur über einen Teil der Länge dieser ersten leitenden Schicht (L1) erstreckt, daß entlang einer sich über den Querschnitt der ersten leitenden Schicht (L1) erstreckenden ersten Linie (EL1) in der isolierenden Schicht (OX) kleine Unterbrechungen vorgesehen sind, daß im Bereich dieser Unterbrechungen jeweils hochdotierte inselförmige in die Epitaxieschicht (EPI) hineinreichende Halbleiterbereiche (HI) vom gleichen Leitungstyp wie die Epitaxieschicht (EPI) vorgesehen sind, die mit der ersten leitenden Schicht kontaktiert sind und somit über die hochohmige Epitaxieschicht jeweils zwischen der Kontaktierstelle mit der ersten leitenden Schicht und der vergrabenen Schicht einen Widerstand (W1) bilden und daß ein erster Meßpunkt (M1) an der als vergrabene Schicht ausgebildeten zweiten leitenden Schicht (BL1) liegt.

13. Halbleiteranordnung nach Anspruch 12,

**dadurch gekennzeichnet,**

daß analog zur zweiten leitenden Schicht (BL1) eine eine dritte leitende Schicht (BL2) bildende weitere vergrabene Schicht vorgesehen ist, daß entlang einer sich über den Querschnitt der ersten leitenden Schicht erstreckenden zweiten Linie (EL2) in der isolierenden Schicht (OX) kleine Unterbrechungen vorgesehen sind, daß im Bereich dieser Unterbrechungen jeweils hochdotierte inselförmige in die Epitaxieschicht hineinragende Halbleiterbereiche (HI) vom gleichen Leitungstyp wie die Epitaxieschicht vorgesehen sind, die mit der ersten leitenden Schicht kontaktiert sind und daß ein zweiter Meßpunkt (M2) an der als vergrabene Schicht ausgebildeten dritten leitenden Schicht (BL2) liegt.

# FIG 1

# FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.3) |
|---|---|---|---|
| A | US-A-4 024 561 (IBM)<br>* Zusammenfassung *<br>----- | 1 | G 01 R 31/26 |
| | | | **RECHERCHIERTE SACHGEBIETE (Int. Cl.3)**<br><br>G 01 R |

Der vorliegende Recherchenbericht wurde für alle Patentansprüche erstellt

| Recherchenort | Abschlußdatum der Recherche | Prüfer |
|---|---|---|
| DEN HAAG | 11-05-1989 | HOORNAERT W. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
································································
& : Mitglied der gleichen Patentfamilie, übereinstimmendes
    Dokument

EPO FORM 1503 03.82 (P0403)